# EUROPEAN PATENT APPLICATION

(11) **EP 4 617 606 A1**
(43) Date of publication of application: **17.09.2025**
(21) Application number: 25161804.7
(22) Date of filing: 05.03.2025
(51) Int. Cl.: F28F 9/02, H01L 23/367

(54) **VAPOR CHAMBER**

(30) Priority: 11.03.2024 CN 202420467640 U
(71) Applicant: Purple Cloud Development Pte. Ltd., Singapore 128424 (SG)
(72) Inventor: Wang, Xue Mei, Hui Zhou City (CN)
(74) Representative: Grünecker Patent- und Rechtsanwälte PartG mbB

(57) **Abstract**

A heat dissipation device includes a vapor chamber, a heatsink, and a heat dissipation plate. The vapor chamber includes a first plate, a second plate that is connected to the first plate to form a chamber between the first and second plates, and a plurality of first support structures disposed within the chamber, opposite ends of each of the first support structures are connected to the first plate and the second plate respectively, the first support structures are disposed with at least two rows and at least two columns, wherein any two adjacent rows of the first support structures are staggered. The heat dissipation plate is disposed in between the heatsink and the vapor chamber so that the heatsink and the vapor chamber are connected to each other via the heat dissipation plate.

## Description

### TECHNICAL FIELD

The present disclosure is related to the field of heat dissipation technology, in particular a vapor chamber that can be coupled to a heat dissipation device.

### BACKGROUND

During operation of electronic devices, the heat generated by the processors must be dissipated quickly and efficiently to keep operating temperatures within a range recommended by manufacturers. As the capability and application of these electronic devices expand, so do the operating speeds of the processors that power them. As electronic devices become thinner and more compact with each new generation, thermal management of these devices becomes more difficult since there is less space between the different heat sources.

Vapor chambers are used to dissipate heat. In general, vapor chambers are formed by flattening heat pipes to around 30% to 60% of their original diameter or by bonding an upper and lower casing together. Vapor chambers are vacuum containers that transfer heat from a heat source via evaporation of a working fluid, which is disseminated by a vapor flow that fills the vacuum, thereby increasing the thermally connected surface area. The vapor flow finally condenses over cooler surfaces, resulting in uniform heat distribution from an evaporation surface (heat source interface) to a condensation surface (greater cooling surface area). Thereafter, condensed fluid then flows back toward the evaporation surface.

### SUMMARY

The invention is as as defined in the appended claims. Aspects of the disclosure provide a vapor chamber. The vapor chamber includes a first plate, a second plate that is connected to the first plate to form a chamber between the first and second plates, and a plurality of first support structures disposed within the chamber, opposite ends of each of the first support structures are connected to the first plate and the second plate respectively, the first support structures are disposed with at least two rows and at least two columns, wherein any two adjacent rows of the first support structures are staggered.

In an embodiment, each of the first support structures has a strip shape.

In an embodiment, each of the first support structures is disposed in a diagonal direction that each of the first support structures is substantially parallel to a diagonal of the vapor chamber. For example, the adjacent rows of the first support structures can be disposed in opposite directions. For example, the adjacent columns of the first support structures can be disposed in opposite directions. In an embodiment, the first support structures are disposed parallel to a side of the vapor chamber.

In an embodiment, the vapor chamber further includes a plurality of second support structures disposed within the chamber, opposite ends of each of the second support structures are connect to the first plate and the second plate respectively, the second support structures are disposed with at least two rows and at least two columns, any two adjacent rows of the second support structures are staggered, wherein the rows of the first support structures and the rows of the second support structures are disposed alternatively.

In an embodiment, the vapor chamber further includes a plurality of third support structures disposed within the chamber, opposite ends of each of the third support structures are connect to the first plate and the second plate respectively, wherein the third support structures are disposed on outer perimeter of the first support structures.

In an embodiment, the first plate further includes a first notch on an edge, a plurality of fourth support structures are disposed adjacent to the notch, opposite ends of each of the third support structures are connect to the first plate and the second plate respectively. In an embodiment, the first plate further includes a second notch that is on the same edge of the first notch.

In an embodiment, the second plate further includes a concave portion at a center, the concave portion faces the first plate and forms the chamber when the first plate connects the second plate.

Aspects of the disclosure provide a heat dissipation device. The heat dissipation device includes the vapor chamber, a heatsink, and a heat dissipation plate that is disposed in between the heatsink and the vapor chamber so that the heatsink and the vapor chamber are connected to each other via the heat dissipation plate.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a perspective view of a vapor chamber 10 according to aspects of the present disclosure.
Fig. 2 illustrates an exploded perspective view of the vapor chamber 10 as shown in Fig. 1.
Fig. 3 illustrates a perspective view of a base plate 11 of the vapor chamber 10 as shown in Fig. 1.
Fig. 4 illustrates a top view of the base plate 11 of the vapor chamber 10 as shown in Fig. 3.
Fig. 5 illustrates a perspective view of a top plate 12 of the vapor chamber 10 as shown in Fig. 1.
Fig. 6 illustrates an exploded front view of a heat dissipation device 100 according to aspects of the present disclosure.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

A vapor chamber can be coupled with a heatsink to dissipate heat that generated from a heat source. A vapor chamber is often made of copper for its exceptionally high thermal conductivity, and a heatsink is often made of aluminum because its lightweight and ease of manufacturing while having a good thermal conductivity. When rapid temperature change occurs frequently, for example, frequent temperature changes between -40°C and 110°C in short period of time, ripples may form on the surface of the vapor chamber that is coupled to or adjacent to the heatsink due to the material difference between the vapor chamber and the heatsink. The ripples formed on the surface of the vapor chamber cause the surface to become uneven, which may affect the heat dissipation efficiency. Therefore, the present disclosure provides solutions to solve the aforementioned problem.

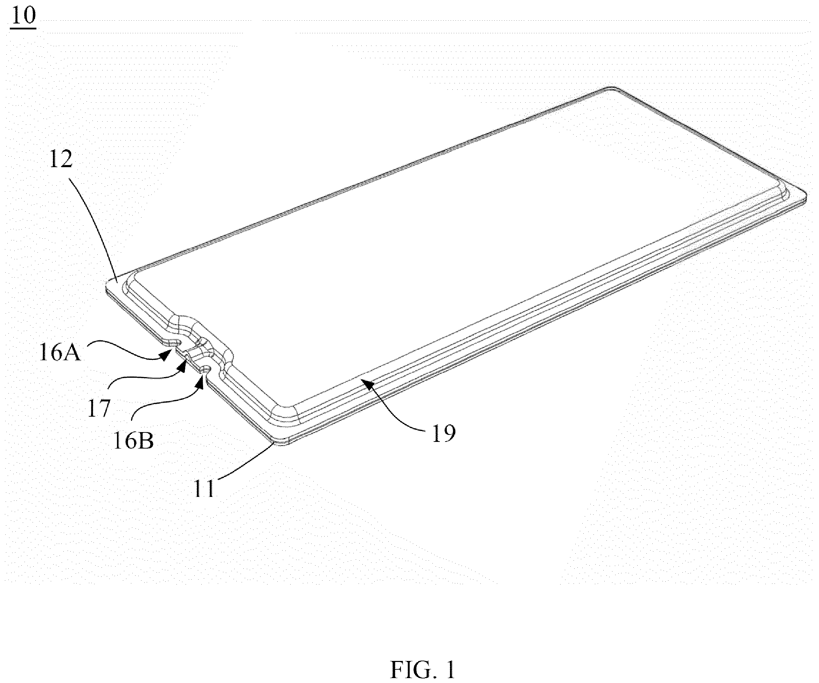

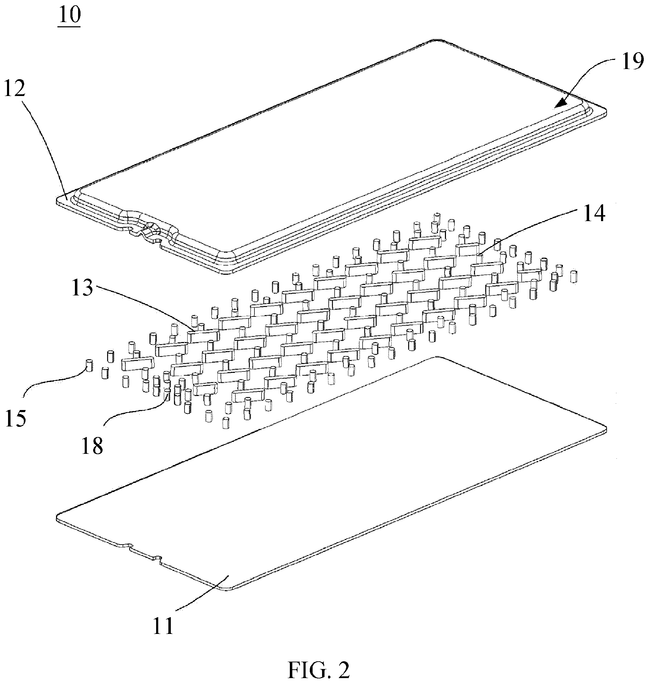

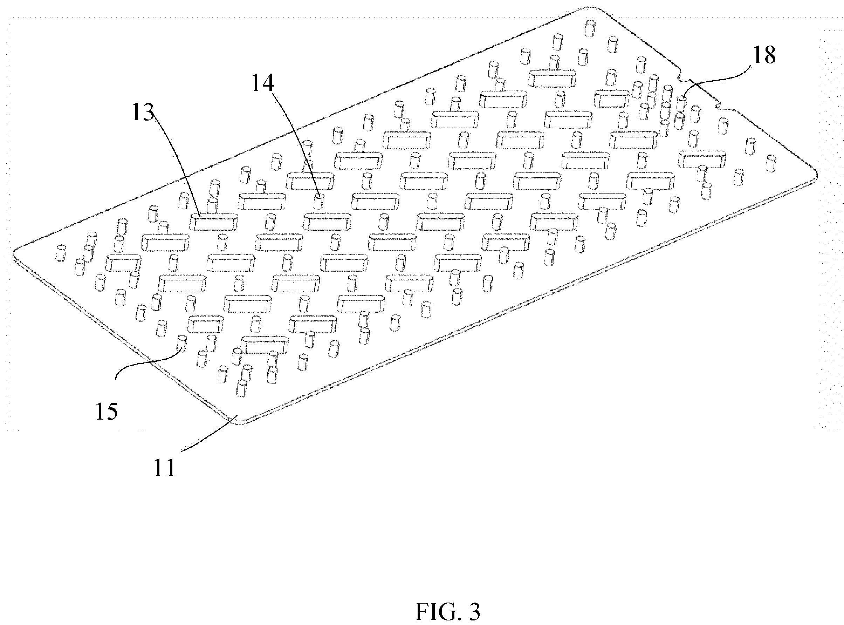

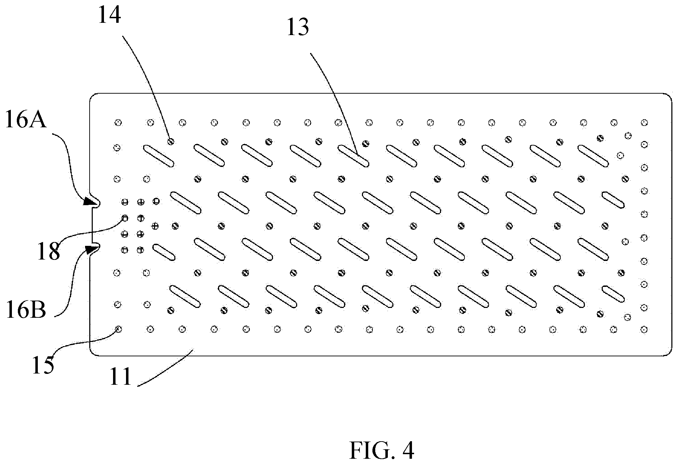

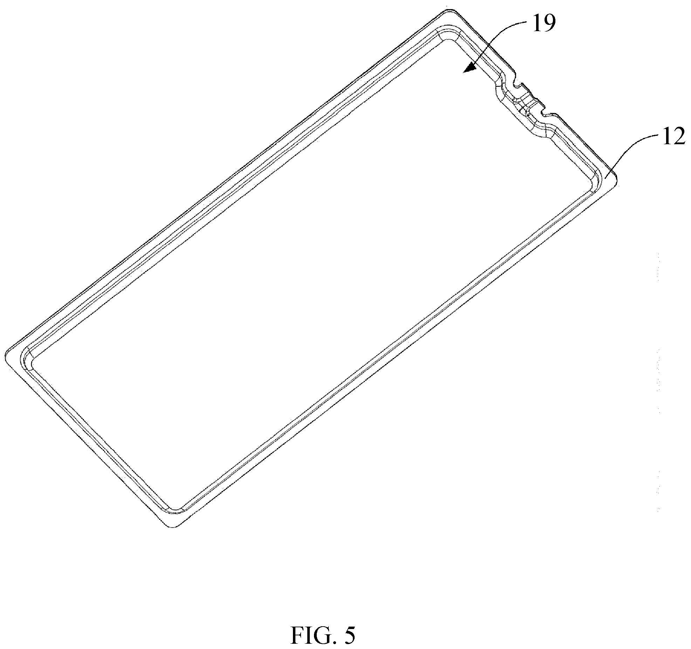

Referring to Figs. 1 to 5. Fig. 1 illustrates a perspective view of a vapor chamber 10 according to aspects of the present disclosure. Fig. 2 illustrates an exploded perspective view of the vapor chamber 10 as shown in Fig. 1. Fig. 3 illustrates a perspective view of a base plate 11 of the vapor chamber 10 as shown in Fig. 1. Fig. 4 illustrates a top view of the base plate 11 of the vapor chamber 10 as shown in Fig. 3. Fig. 5 illustrates a perspective view of a top plate 12 of the vapor chamber 10 as shown in Fig. 1.

The vapor chamber 10 includes a base plate 11, a cover plate 12 and plurality of support structures 13, 14, 15, and 18. The cover plate 12 has a concave structure 19 and is disposed on the base plate 11 to form cavity within. The plurality of support structures 13, 14, 15, and 18 are disposed on the base plate 11 and within in chamber. Specifically, the support structures 13, 14, 15, and 18 are disposed within the concave structure 19. The vapor chamber 10 also includes an inlet 17 on a side of the vapor chamber 10. The inlet 17 can be used to fill the vapor chamber 10 with a cooling fluid. In an embodiment, the inlet 17 is located at the shorter side of the vapor chamber 10. In some embodiments, the inlet 17 can be located at the longer side of the vapor chamber 10. The vapor chamber 10 can further include notches 16A, 16B that are located on opposite sides of the inlet 17 and on the same side of the vapor chamber 10 as of the inlet 17.

The plurality of support structures 13, 14, 15, and 18 are disposed on the base plate 11. The support structures 13, 14, 15, and 18 can all be made of copper. The support structures 13 can have a strip shape, while the support structures 13, 15, and 18 can each have a cylinder shape. In some embodiments, the support structures 13, 14, 15, and 18 can be the same shape. In some embodiments, the support structures 13, 14, 15, and 18 can each have different shape. The support structures 13, 14, 15, and 18 are connected to the inner surface of the base plate 11 and the inner surface of the cover plate 12. The support structures 13 can all have the same length, but not limited to this. In some embodiments, the support structures 13 can have different lengths. Similarly, the support structures 13 can have the same width, but not limited to this. In some embodiments, the support structures 13 can have different widths.

In an embodiment, the support structures 13 are disposed in an angle compared to the longer side of the vapor chamber 10. Namely, the support structures 13 are disposed substantially along the diagonal of the vapor chamber. In some embodiments, the support structures 13 can be disposed in an angle compared to the short side of the vapor chamber 10. In some embodiments, the support structures 13 can be disposed substantially parallel to the longer side or shorter side of the vapor chamber 10.

The support structures 13 are disposed in multiple rows and multiple columns. For example, as shown in Fig. 4, the support structures 13 are disposed in 4 rows and 10 columns. Any two adjacent rows of support structures 13 are disposed staggered. For example, as shown in Fig. 4, each support structure 13 in the second row is disposed staggered to the corresponding support structure 13 in the first row. The support structures 14 are also disposed in multiple rows and multiple columns. For example, as shown in Fig. 4, the support structures 14 are disposed in 5 rows and 10 columns. The support structures 14 are disposed in a such way so that each row of the support structure 13 is in between any two adjacent rows of the support structures 14.

The support structures 15 are disposed on outer perimeter of the cavity of the vapor chamber 10. The support structures 18 are disposed adjacent to the inlet 17 of the vapor chamber 10. Each support structure 13, 14, 15, and 18 can provide support to the vapor chamber 10 at each location to increase the stability of the vapor chamber 10, which can reduce the formation of ripples during extensive temperature changes. Further, the support structures 13, 14, 15, and 18 can provide heat conduction to the vapor chamber 10, evening out the heat dissipation and increasing the heat dissipation efficiency.

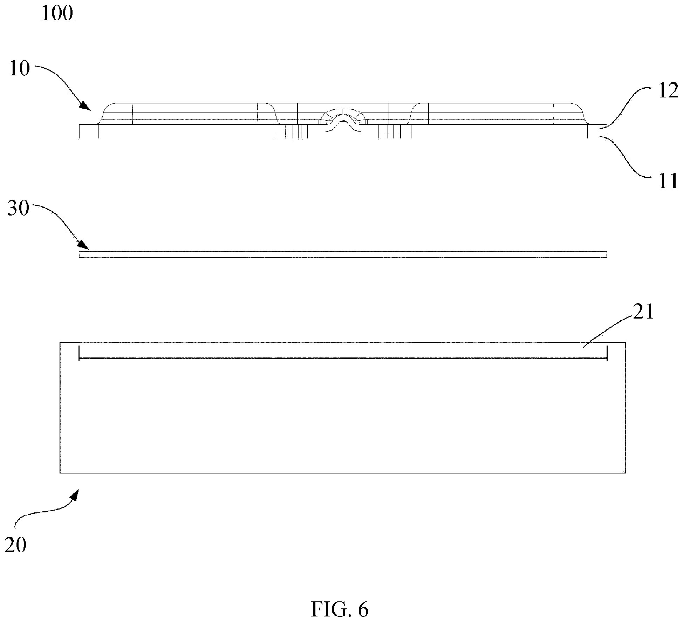

The present disclosure provides a heat dissipation device that utilizes the vapor chamber 10 as disclosed above. Fig. 6 illustrates an exploded front view of a heat dissipation device 100 according to aspects of the present disclosure. The heat dissipation device 100 can include the vapor chamber 10 as shown in Fig. 1, a heatsink 20, and a copper plate 30. The heatsink 20 can be made of aluminum and includes a groove 21 which the copper plate 30 can be disposed within. The vapor chamber 10 is thermally coupled to the copper plate 30. Namely, the vapor chamber 10 is coupled to the heatsink 20 via the copper plate 30.

By adding the copper plate 30 between the vapor chamber 10 and the heatsink 20, the thickness of the conductive material between the vapor chamber 10 and the heatsink 20 is increased. In this way, the heat dissipation efficiency can be improved around 15-20% compares to that direct connection between the vapor chamber 10 and the heatsink 20. Further, the heat dissipation device 100 can have heat dissipating more evenly, preventing the outer surface of the vapor chamber to form ripples.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A vapor chamber (10), comprising:
a first plate (11);
a second plate (12) that is connected to the first plate (11) to form a chamber between the first and second plates (11, 12); and
a plurality of first support structures (13) disposed within the chamber, opposite ends of each of the first support structures (13) are connected to the first plate (11) and the second plate (12) respectively, the first support structures (13) are disposed with at least two rows and at least two columns,
wherein any two adjacent rows of the first support structures (13) are staggered.

2. The vapor chamber (10) of claim 1, wherein each of the first support structures (13) has a strip shape.

3. The vapor chamber (10) of claim 1 or 2, wherein each of the first support structures (13) is disposed in a diagonal direction that each of the first support structures (13) is substantially parallel to a diagonal of the vapor chamber (10).

4. The vapor chamber (10) of one of claims 1 to 3, wherein the adjacent rows of the first support structures (13) are disposed in opposite directions.

5. The vapor chamber (10) of one of claims 1 to 4, wherein the adjacent columns of the first support structures (13) are disposed in opposite directions.

6. The vapor chamber (10) of claim 1 or 2, wherein the first support structures (13) are disposed parallel to a side of the vapor chamber (10).

7. The vapor chamber (10) of one of claims 1 to 6, further comprises a plurality of second support structures (14) disposed within the chamber, opposite ends of each of the second support structures (14) are connect to the first plate (11) and the second plate (12) respectively, the second support structures (14) are disposed with at least two rows and at least two columns, any two adjacent rows of the second support structures (14) are staggered, wherein the rows of the first support structures (13) and the rows of the second support structures (14) are deposed alternately.

8. The vapor chamber (10) of claim 7, further comprises a plurality of third support structures (15) disposed within the chamber, opposite ends of each of the third support structures (15) are connect to the first plate (11) and the second plate (12) respectively, wherein the third support structures (15) are disposed on outer perimeter of the first support structures (13).

9. The vapor chamber (10) of claim 8, wherein the first plate (11) further includes a first notch (16A) on an edge, a plurality of fourth support structures (18) are disposed adjacent to the notch (16A), opposite ends of each of the fourth support structures (18) are connect to the first plate (11) and the second plate (12) respectively.

10. That vapor chamber (10) of claim 9, wherein the first plate (11) further includes a second notch (16B) that is on the same edge of the first notch (16A).

11. The vapor chamber (10) of one of claims 1 to 10, wherein the second plate (12) further includes a concave portion (19) at a center, the concave portion (19) faces the first plate (11) and forms the chamber when the first plate (11) connects the second plate (12).

12. A heat dissipation device (100), comprising:
a vapor chamber (10), comprising:
a first plate (11);
a second plate (12) that is connected to the first plate (11) to form a chamber between the first and second plates (11, 12); and
a plurality of first support structures (13) disposed within the chamber, opposite ends of each of the first support structures (13) are connected to the first plate (11) and the second plate (12) respectively, the first support structures (13) are disposed with at least two rows and at least two columns, wherein any two adjacent rows of the first support structures (13) are staggered and any two adjacent columns of the first support structures (13) have no other support structure in between;
a heatsink; and
a heat dissipation plate (30) disposed in between the heatsink and the vapor chamber (10) so that the heatsink and the vapor chamber (10) are connected to each other via the heat dissipation plate (30).

13. The heat dissipation device (100) of claim 12, wherein the heatsink includes a groove (21) where the heat dissipation plate (30) is at least partially disposed in.

14. The heat dissipation device (100) of claim 12 or 13, wherein each of the first support structures (13) has a strip shape.

15. The heat dissipation device (100) of one of claims 12 to 14, wherein each of the first support structures (13) is disposed in a diagonal direction that each of the first support structures (13) is substantially parallel to a diagonal of the vapor chamber (10).

16. The heat dissipation device (100) of one of claims 12 to 15, wherein the adjacent rows of the first support structures (13) are disposed in opposite directions.

17. The heat dissipation device (100) of one of claims 12 to 17, wherein the adjacent columns of the first support structures (13) are disposed in opposite directions.

18. The heat dissipation device (100) of one of claims 12 to 14, wherein the first support structures (13) are disposed parallel to a side of the vapor chamber (10).

19. The heat dissipation device (100) of one of claims 12 to 18, further comprises a plurality of second support structures (14) disposed within the chamber, opposite ends of each of the second support structures (14) are connect to the first plate (11) and the second plate (12) respectively, the second support structures (14) are disposed with at least two rows and at least two columns, any two adjacent rows of the second support structures (14) are staggered, wherein the rows of the first support structures (13) and the rows of the second support structures (14) are alternating disposed.

20. The heat dissipation device (100) of claim 19, further comprises a plurality of third support structures (15) disposed within the chamber, opposite ends of each of the third support structures (15) are connect to the first plate (11) and the second plate (12) respectively, wherein the third support structures (15) are disposed on outer perimeter of the first support structures (13).

21. The heat dissipation device (100) of claim 20, wherein the first plate (11) further includes a first notch (16A) on an edge, a plurality of fourth support structures (18) are disposed adjacent to the notch (16A), opposite ends of each of the fourth support structures (18) are connect to the first plate (11) and the second plate (12) respectively.

22. The heat dissipation device (100) of claim 21, further comprises a second notch (16B) that is on the same edge of the first notch (16A).

23. The heat dissipation device (100) of one of claims 12 to 22, wherein the second plate (12) further includes a concave portion (19) at a center, the concave portion (19) faces the first plate (11) and forms the chamber when the first plate (11) connects the second plate (12).
